Europäisches Patentamt

(19) European Patent Office

Office européen des brevets

(11) **EP 0 907 250 A2**

(12) **EUROPEAN PATENT APPLICATION**

(43) Date of publication:
07.04.1999 Bulletin 1999/14

(51) Int. Cl.$^6$: **H03H 11/04**

(21) Application number: 98117881.7

(22) Date of filing: 21.09.1998

(84) Designated Contracting States:
AT BE CH CY DE DK ES FI FR GB GR IE IT LI LU
MC NL PT SE
Designated Extension States:
AL LT LV MK RO SI

(30) Priority: 25.09.1997 SG 9703570

(71) Applicant: MOTOROLA LTD
Alencon Link, Basingstoke,
Hampshire RG21 7PL (GB)

(72) Inventor:
Tsui, Mung Laam,
Flat B 26/F King Tien
Hong Kong (HK)

(74) Representative:
Gibson, Sarah Jane et al
Motorola
European Intellectual Property Operations
Midpoint
Alencon Link
Basingstoke, Hampshire RG21 7PL (GB)

(54) **Integrated analog low-pass filter**

(57) A filter is formed by a transconductance amplifier (202) controlling the bias and active load currents of a capacitance amplification circuit. The capacitance amplification circuit includes a Miller integrator with a bias-setting circuit where the Miller integrator includes an amplifier (14), an on-chip capacitor (38), a resistor (214) and an active load current (Iout1) from a variable current source (94). As the other balanced portion of the capacitance multiplication circuit, the bias-setting circuit includes a bias current (Iout2) from a second variable current source (106), a second resistor (212), and a second amplifier (15).

*FIG.2*

## Description

### Technical Field

This invention relates in general to filters and in particular to fully integrated low-pass active analog filters below 1 Hz.

### Background

Modern day automotive battery charging systems use an alternator and an electronic voltage regulator. Automotive alternators have to supply a constant temperature-dependent voltage (such as 10mV/C for one type of cars) that is independent of the load current. This is accomplished by a regulator switching ON and OFF the alternator's field current to produce a time-varying signal that is used to recharge a vehicle's battery. However, this time-varying signal may be coupled into and corrupt other circuits, such as the voltage regulation of the regulator via conductive or radiated phenomenon.

Automobile circuits, such as an alternator control module including voltage regulation, are commonly made available for integration onto integrated circuits (IC) chips. Most of the automotive integrated circuits are now mixed signal processed integrated devices, for example, containing both metal oxide semiconductor field-effect transistor (MOSFET) and bipolar transistor devices. This mixed-signal power process may be used to build MOS and power devices on top of a bipolar process which is commonly termed as the BIMOS process. However, as more and more circuits can be placed on the same alternator control module because of the mixed signal process, the extra circuits within the same module can increase the interference on each other.

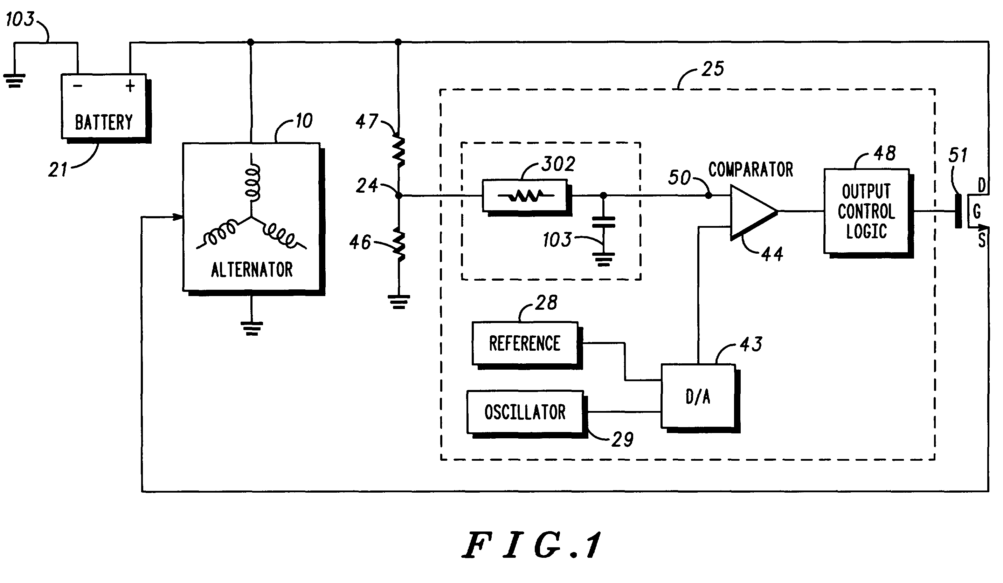

For example, one such critical application that can be affected is the alternator voltage regulator integrated circuit. FIG. 1 illustrates a simplified block diagram of a prior-art pulse-width-modulation (PWM) voltage switching regulation scheme in an alternator voltage regulator circuit of an alternator control IC chip 25. The alternator regulator IC 25, designed to operate in an automotive battery system, is intended to control the voltage in an automotive system that uses a three-phase alternator 10 with a rotating field winding. The IC 25 regulates the alternator output voltage by acting on its excitation or field current. This is accomplished by switching the alternator field coil. The rotating field-winding of the three-phase alternator 10 is acting as an inductor. During the "ON" phase, the field inductor rotor is charged through a power switching device 51 of the regulator.

The regulator operates in a Pulse Width Modulated (PWM) mode at a constant frequency of approximately 70 - 500Hz. The PWM approach controls the duty cycle and therefore the average field current. A typical 78Hz regulator frequency is generated by an internal oscillator 29 of the switching regulator to set the switching speed of the charging and discharging regulation control scheme. A feedback-loop is associated with this scheme to determine the relative percentage of charging time and discharging time that is needed for the output voltage to be equal to a desired reference voltage. This reference voltage is provided by a temperature stable voltage reference 28 with a deliberately built-in temperature coefficient.

Since the reference voltage is built inside the regulator control IC chip 25, the battery voltage needs to be divided and fedback to the IC for comparison by a comparator 44. Hence, the output voltage from an external battery 21 and an external alternator 10 is sensed by a feedback pin 24 by way of external voltage divider resistors 46 and 47. The regulated system voltage or battery voltage is then determined by these voltage divider resistor values 46 and 47.

Since the battery voltage is fedback to the feedback pin 24 after it is divided down by the resistor divider 46 and 47, the divided feedback voltage, representative of the battery voltage, is accurate only if there is no other circuit drawing current from the resistive divider 46 and 47. However, the bipolar implementation of the comparator 44 requires an input bias current for its operation. Hence, an optional buffer to provide high impedance may be inserted at the feedback pin 24 because a buffer has a high impedance input (low input bias current) and a low impedance output (high driving capability). The feedback output 24 is then the accurate feedback voltage that will go to one input 50 of the comparator 44 as the regulation output voltage.

The (buffered) output voltage is then compared by the regulator's comparator 44 to a descending ramp waveform generated by an internal data-to-analog converter DAC 43 to provide a desired regulation voltage reference. The peak of the ramp waveform is generated by the temperature stable voltage reference 28. When the two voltages are approximately equal, the output of the regulator comparator 44 changes state and the gate of an external or internal switch is pulled low (turned OFF) by an output control logic 48 for the duration of the output frequency clock cycle.

Preferably, the switch is in the form of a power MOSFET device 51 that is powerful enough to handle the load. For simplicity in drawing, the MOSFET 51 is shown external to the chip 25, however, integration of the MOSFET 51 into the chip 25 may be possible if the process allows. The DAC begins its descending ramp waveform and the MOSFET is turned ON until the regulator comparator output again changes state. This ongoing cycle constitutes the pulse-width-modulation PWM technique used to control the system voltage.

The drain of the MOSFET device 51 is connected to the battery 21 and the source of the MOSFET device 51 is connected to the field-winding of the alternator 10 that is acting as an inductor. The MOSFET 51 is driven by the output control logic 48 of the regulator chip to control the alternator output voltage by switching ON and OFF the alternator field current.

Functionally, the voltage output information is taken at the output of the alternator 10 or at the battery 21 terminals. The alternator field and stator coils are inductively coupled together. Each time the field current is turned ON the magnetic field changes and a voltage is induced in the stator coils and charges-up the capacitor (battery 21) to replenish charge losses. Hence, the capacitor's or battery 21 voltage rises to a higher value when the power switch 51 is turned ON. The feedback loop based on the voltage comparison thus works to control the timing of charging/discharging until the re-charged battery voltage is the same as the reference voltage.

When the switching switch or MOSFET 51 turns OFF, the energy required by the load is supplied by another energy storage element, such as a capacitor. In this automotive case, the battery can be considered as acting like a large capacitor. If the load is large, the capacitor (the battery) voltage will drop.

Since a alternator is an inductive machine with a varying current speed (switching ON and OFF) and a stream of flowing electrons with changing speed will generate electromagnetic fields (radiation) around it, the alternator will emit electromagnetic radiation. The more inductive the alternator (the larger L) and the faster rising and falling of the switching (high d$i$/d$t$) speed, the stronger the radiation V. In such an automotive environment, there are numerous other inductive machines, such as the car engine which are the main sources of interferences that will disturb the time-varying feedback voltage signal before it even enters the IC or chip.

Hence, the feedback signal (optionally buffered) has to be filtered before it is injected onto the input of the comparator 44. Low pass filters are commonly used to eliminate the system noise that is higher than the regulation frequency in order to achieve accurate regulation voltage.

Similarly to the integrated automotive circuit, low pass filters are desirable to be implemented at the integrated circuit level in the first place, instead of being used as a fix afterwards, to remove interferences on those critical voltage signals entering the chip. However, the implementation of very low frequency analog filters in integrated circuits poses a challenge because on-chip capacitors are limited to quite low values in order not to consume excessive silicon area. As an example, if a 100Hz first order low pass filter is implemented as a simple RC passive circuit and a filtering capacitor 103 is chosen as $C_F$ = 100pF, then a filtering resistor 302 has to be $R_F$ = 15.9 mega ohms. Clearly such a resistor would occupy a vast area if it were implemented directly using some resistive layer of a standard IC fabrication process. Consequently, the resistances needed have to be realized by other means such as active circuits, or special circuit techniques must be used to achieve the desired very large time constants without needing unfabricatable large passive elements.

In active circuits, it is sometimes necessary to use diffusions with large resistances per unit square for feasible integration. These diffusions are inevitably associated with large temperature coefficients due to process limitation. Alternator voltage regulators are specified to regulate battery charging systems with a stable temperature coefficient voltage for a wide temperature range from -40degC to 150degC.

Temperature also affects the active filter's offset voltage. Offset voltage is always temperature dependent and the value changes with the silicon junction temperature. By definition, offset voltage is the voltage difference between the electrical signal input voltage and the electrical output signal at the steady state caused by the insertion of the filter circuit. The offset voltage $I_{os}$ x $R_F$ developed by an offset current $I_{os}$ flowing through the filtering resistor $R_F$ will be exacerbated by temperature changes due to the temperature coefficient of $R_F$ and cause temperature drift in the regulation voltage temperature coefficient if the active devices are mismatched.

Furthermore, a high output offset voltage is unavoidable if the low pass filter directly drives a next stage circuit that takes a finite input bias current, such as a bipolar comparator, when the low pass circuit's output is a high impedance node. Any device mismatch due to the driving of a next stage circuit which takes a finite bias current will be inevitably reflected as an offset voltage across a low pass filter resistor to result in a limited driving capability.

To prevent the existence of a high output offset voltage, a resistor $R_F$ of minimal size is highly desirable to make the circuit a far more ideal low pass filter for the alternator voltage regulator application. Hence, not only does the low-pass filter need to be integratable, and preferably with the integrated voltage regulation circuit, but a variety of other demands are placed on the filter, including low dynamic distortion, low output offset, and high driving capability. Such demands are exacerbated by temperature, processing, and other factors. Accordingly, there is a need for a fully integrated low-pass filter operable below 1 Hz that has low dynamic distortion, output offset, temperature drift but a high driving capability.

## Summary of the Invention

Briefly, according to the invention, there is provided a method for integrating a low pass (LP) active analog filter and a resultant LP integrated circuit needing no $R_F$ and external components. It uses a medium size on-chip capacitor, a differential output transconductance amplifier, and a Miller integrator with a bias setting circuit. The output voltage is compared with the input signal and the resulted error voltage is converted by the transconductance amplifier into a current symmetrically to adjust the bias setting circuit until the difference approaches zero. The time constant of the low pass filter circuit is a function of the transconductance of the amplifier and the Miller effect produced by the on-chip capacitor and its associated bias setting circuit. The filter's cutoff frequency is electrically adjustable to less than 1 Hz. The feedback configuration of the circuit allows the filter to have low dynamic distortion, low temperature output offset drift and good driving capability.

**Brief Description of the Drawings**

FIG. 1 is a block diagram illustration of a PWM regulation scheme in an alternator voltage regulator;
FIG. 2 is a circuit diagram of a low pass active analogue filter circuit, in accordance with the present invention; and
FIG 3 is small signal equivalent circuit of the capacitor multiplicator of FIG. 2, in accordance with the present invention.

**Detailed Description of the Preferred Embodiment**

While the specification concludes with claims defining the features of the invention that are regarded as novel, it is believed that the invention will be better understood from a consideration of the following description in conjunction with the drawing figures, in which like reference numerals from the background of FIG. 1 are carried forward. For example, the voltage output signal 50 is the filtered to-be-accurate feedback voltage that will go to one input of the comparator 44 of FIG. 1.

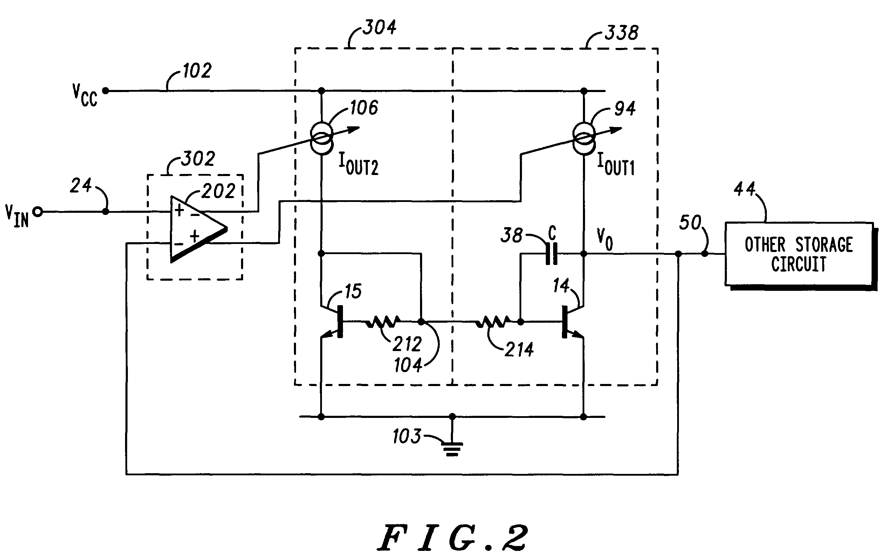

Referring to FIG. 2, the input signal $V_{in}$ is applied to one input of a transconductance amplifier 202 having a first polarity 24 for receiving it as a reference signal and for filtering it. The other input of the transconductance amplifier 202, having a second polarity, is connected to the output node, or an amplified feedback port 50, of a capacitor amplification circuit, in accordance with the teachings of the present invention.

As its differential output, the transconductance amplifier 202 similarly, has a first output of a first polarity and a second output of a second polarity. The second output of the transconductance amplifier 202 is coupled to a first variable current source 106 for controlling the bias current of the capacitance amplification circuit. The first output is coupled to a second variable current source 94 ($I_{out1}$) for controlling the active load current of the capacitance amplification circuit.

The capacitance amplification circuit is coupled between first and second supply terminals or nodes 102 and 103 and includes a Miller integrator 338 with a bias-setting circuit 304. The Miller integrator 338 includes a gain amplifier 14, preferably implemented as a common-emitter NPN bipolar transistor, an on-chip capacitor 38, a resistor 214 and an active load current Iout 1 from a variable current source 94. As the other balanced portion of the capacitance multiplication circuit, the bias-setting circuit 304 includes a bias current Iout2 from a variable current source 106, a resistor 212, and an amplifier 15, preferably implemented as a diode-connected common emitter NPN bipolar transistor. A very large time-constant integrator is formed by feeding the output current from the transconductance amplifier 202 into the Miller multiplicated capacitor 38.

Node 102 is also the supply voltage node or positive rail for supplying a previously regulated or unregulated supply voltage $V_{cc}$ or $V_s$. $V_{cc}$ is an internally regulated power supply from the battery voltage. Since the battery voltage is noisy and quite high (around 14-15V), the common practice is to have it regulated to a stable voltage and supply the internal circuits in the chip.

As part of the bias-setting circuit, two high-side mirrored current zero temperature coefficient (TC) sources 94 and 106 are adapted from a source or supply voltage available at the first supply node or terminal 102 in a current source stage. The current source stage is coupled to an internal reference for setting a level of current. Generating a zero TC current source is a well known technique in integrated circuit (IC) design. A zero TC current source generator provides a zero TC reference current which is copied by all the other circuits in the chip that need a zero TC current source.

One such circuit is the zero TC current source ($I_{bias}$) inside the transconductance amplifier 202 that is supplied by an input bias current of 2 x $I_{202}$. This zero TC current source is then divided by two ($I_{bias}/2$) to form two equal voltage-controlled variable current sources $I_{202}$, at equilibrium, for providing two transconductance amplifier currents from a differential output. These two differential outputs $I_{out1}$ and $I_{out2}$ are then replicated, in the form of two variable current sources 94 and 106, from the supply at terminal 102, and provided by the differential output of the transconductance amplifier 202 to supply the filter current of the capacitance amplification circuit, consisting of a bias current $I_{out2} = I_{bias}/2$ from the current source 106 and an active load current $I_{out1} = I_{bias}/2$ from the current source 94.

4

Both amplifiers 14 and 15 have their collectors connected to the first supply node 102 at the positive rail for receiving the positive supply voltage via the two variable current sources 94 and 106 respectively. The diode-connected NPN bipolar transistor 15 has its collector connected to its base via the first resistor 212 and to the current source 106. The base of the gain transistor 14 is coupled to the base of the diode-connected transistor 15 via the second intervening resistor 214 such that the two resistors 212 and 214 intersect at a fixed bias port 104 that is connected to the collector of the transistor 15. The emitters of the first and second (arbitrarily labeled as first and second for simplicity) transistors 15 and 14 are connected to a second supply or another common terminal node 103 (circuit ground or negative rail). The pair of common emitter amplifiers 14 and 15 each has a first and a second node coupled to a common fixed bias reference port 104, at the collector of the bipolar transistor 15, that is coupled to the first variable current source 106 via their respective base resistors 214 and 212.

Resistor 214, connected between the collector of the transistor 15 and the base of the other transistor 14, contributes to the location of the cutoff frequency in the low pass filter design. The other resistor 212 between the base and collector of the transistor 15 is used to balance the previous resistor 214 mentioned so that the bases of the transistors 212 and 214 are biased at the same voltage (i.e. the voltage at the collector of the transistor 15 minus the voltage developed across the resistor 212 by the base current). So, preferably the two resistors 212 and 214 should have the same value R for proper balance.

In other words, transistors 15 and 14 form a base coupled (via intervening resistors 212 and 214) amplifier that has its bias set at the fixed bias port 104 via their intervening resistors 212 and 214 of their commonly connected bases by the current source 106 to serve as a bias setting circuit. The collector currents are set by the current sources 106 and 94. The Iout2 current from the variable current source 106 flows through the diode-configured transistor 15 and set up a base voltage for transistor 14. Since the transistors 14 and 15 share the same base voltage because the two base resistors 212 and 214 are designed to be equal, and the two transistors 14 and 15 have the same collector current flowing through them, transistors 14 and 15 will also have the same emitter voltage as the collector current is governed directly by the base-emitter voltage of the bipolar junction transistor:

$$V_{be} = VT\ln(I_c/I_s)$$

In normal variations of semiconductor bipolar processing, the base emitter Junction voltage $V_{be}$ of a bipolar transistor is a function of the saturation current ($I_s$) of the bipolar transistor which can vary over temperature. Thus, for self-referencing and temperature independence, an internal reference voltage source thus includes the transistor 15, the resistor 212, and the zero TC current source 106. The current from the current source 106 flows to the transistor 15 and finally to ground to provide an internal temperature reference to the base of the common-based transistor 14 via the two intervening resistors 212 and 214 for providing a collector or output voltage at node 50.

As part of the capacitance amplification circuit, bipolar transistors 15 and 14, variable current sources 106 and 94, and resistors 212 and 214 set-up a bias circuit to provide a high impedance characteristic at the output node 50. The feedback capacitor 38 between the input base and output collector nodes (both have a high impedance) of the impedance inverting amplifier 14 gives a Miller amplified capacitance. To form the Miller integrator 338, the collector node of the gain amplifier 14, provides an amplified feedback port at its collector output (or the output node 50 for providing a filtered output) and this collector output is also coupled to the second variable current source 94. A feedback or filtering capacitor 38 has one end coupled to the input port or base node of the amplifier 14 and a second end coupled to the amplified feedback port 50 or collector output node of the transistor 14. The feedback capacitor preferably comprises a monolithic capacitor for forming an on-chip capacitor of around 150pF.

Since the base of the transistor 14 is connected to the second resistor 214 and the output of the second variable current source 94, the collector of the transistor 14 sees the unfiltered input voltage by way of its variable current source 106 and 94 variations, as controlled and intervened by the transconductance amplifier 202. Hence, both base and collector nodes of the transistor 14 are considered high impedance nodes. These base and collector high impedance nodes, together with the gain of the transistor 14, create a Miller effect which effectively increases the value of the filtering capacitor 38 by a factor that is a function of the gain of the transistor 14.

Basically, the transconductance amplifier 202 is a voltage-to-current converter where an output current is produced that is proportional to an input voltage. With two inputs 24 and 50 and a differential output to provide two output currents $I_{out1}$ and $I_{out2}$ of opposite polarity, the output current of one of its two outputs is directly proportional to the differential voltage of the transconductance amplifier 202. The differential voltage developed across its input nodes is governed by the transconductance (proportionality factor $g_m$) of the transconductance amplifier 202. The transconductance is electrically adjustable by conventional transconductance amplifier design techniques and is equal to $(I_{out1} - I_{out2}) / (V_{in} - V_o) = g_m = 1/R_f$, where the differential current $(I_{out1} - I_{out2})$ is equivalent to $I_{in}$.

The total amount of the two output current remains a constant over time and temperature, as set up by the zero TC current reference. The DC current of each of the two voltage-controlled current sources, inside the transconductance amplifier 202, at steady state or equilibrium, is $I_{bias}/2 = I_{202}$. In other words, the two current outputs $I_{out2}$ and

$I_{out1}$ are equal at equilibrium. But any current increase in one output is matched by a decrease of an equal amount of current in the other output.

When a voltage difference or differential voltage +dV is developed across the transconductance inputs, one voltage controlled current source will increase its current to $I_{bias}/2 + (g_m \times dV)$ while the other voltage controlled current source will decrease its current to $I_{bias}/2 - (g_m \times dV)$. Alternatively, if the voltage is -dV across the transconductance inputs, the first voltage controlled current source will have a current equal to $I_{bias}/2 + g_m \times (-dV) = I_{bias}/2 - g_m \times dV$ and the other one will have a current equal to $I_{bias}/2 - gm \times (-dV) = I_{bias}/2 + (g_m \times dV)$. Even though these two current outputs change simultaneously, albeit in the opposite direction, their sum is always equal to $2 \times I_{202}$ which is set by the bias reference current. Since $I_{out1}$ and $I_{out2}$ are replica of the transconductance amplifier outputs, they are inter-related and cannot be controlled independently.

By using a differential output, $I_{out1}$ and $I_{out2}$ are forced to be equal when equilibrium balance has been reached. Since the two transistors 14 and 15 are biased at the same base voltage, they draw the same amount of current ($I_{out1} = I_{out2}$). When $V_{in} = V_o$ at the two nodes 24 and 50, respectively, the current Iout2 from the first variable current source 106 can be considered as a reference or bias current. The additions of the first resistor 212 which matches the second resistor 214 in terms of value and layout orientation make sure that the two bipolar transistors 14 and 15 each has the same base bias so that the transistor 14 can sink an equal amount of current such as that referenced or bias current $I_{out2}$ sunk by the transistor 15 from the first variable current source 106. Since the devices making-up the second variable current source 94 are sized equal to those making-up the first variable current source 106, and under the situation of a perfect match, the current Iout1 from the second variable current source 94 should also equal $I_{out2}$. When the current source 94 and transistor 14 are thus perfectly matched with the current source 106 and transistor 15 respectively, transistor 14 should ideally take an equal collector current as that of transistor 15 supposing that the base current is negligible.

As is known, the DC offset voltage of an analog low pass filter is measured by the voltage difference between the input voltage and output voltage. The output offset voltage is determined by the accuracy of the closed loop and how well the input stage devices of the transconductance amplifier 202 are matched. In other words, the lower the input offset voltage of the transconductance amplifier 202, the lower the output offset voltage. A transconductance amplifier can have a very low input offset voltage (in uV range) depending on how well its input stage is designed.

An extremely low output offset voltage results from the present invention because both inputs of the transconductance amplifier 202 are held at approximately the same voltage, in a feedback configuration. At equilibrium, when $V_{in} = V_o$, the currents $I_{out1}$ and $I_{out2}$ from the two variable current sources 94 and 106 are designed to be equal, as controlled by the differential output of the feedback configured transconductance amplifier 202. The feedback configuration will continue to adjust $I_{out1}$ and $I_{out2}$ such that the voltage at the output node equals the voltage at the input node at equilibrium.

Furthermore, since the transistor 15 sinks an equal amount of current as the transistor 14 and $I_{out1} = I_{out2}$, no excessive current can discharge or charge up the filtering capacitor 38, at the output node 50, when $V_{in} = V_o$, at equilibrium. Therefore the output node 50 is a high impedance node (floating). However, the feedback configuration will force this delicate floating (high impedance node) to equal the input voltage. In other words, if the feedback loop is broken, it is just a high impedance but the feedback configuration transforms the node into a low impedance node. It is thus the feedback configuration that keeps both inputs of the transconductance amplifier 202 at a equal voltage.

When the electrical input $V_{in}$ voltage, at the input node 24, rises above the output signal, at node 50, the balance of the transconductance amplifier 202 is disturbed. The voltage difference developed across the transconductance amplifier 202 inputs is converted into a differential output current with $I_{out1}$ and $I_{out2}$ going into different directions (or of opposing polarities). The output current Iout1 controlled by the transconductance amplifier increases while the opposite polarity output current Iout2 decreases. Since the voltage across the input nodes of the transconductance amplifier is translated into changes in the output currents, the output currents will no longer be equal, i.e., $I_{out1}$ and $I_{out2}$ will be different. This imbalance of $I_{out1}$ and $I_{out2}$ results in the discharge/charge of the capacitor 38. However, transistor 14 can only take a collector current equal to $I_{out2}$ because it is biased by transistor 15. The differential current ($I_{out1} - I_{out2}$) thus formed charges up the capacitor governed by the Miller effect of the gain transistor Q2 14 to compensate for the reduced output voltage, over the input voltage, when the electrical output signal decreases or the input signal increases. Hence, the rate of change of the current in response to the input voltage change is controlled by the gm of the transconductance amplifier 202 and the value of the capacitor 38 just like in an RC low pass filter where the rate of change of the input current is controlled by the values of the resistor and capacitor.

On the other hand, when the electrical output signal voltage at node 50 rises above the input signal, the voltage difference developed across the transconductance amplifier inputs is converted into a differential output current with $I_{out1}$ and $I_{out2}$ going into different directions. This time, $I_{out2}$ increases to a value higher than $I_{out1}$. The stored voltage at the capacitor 38 is discharged until the output and input voltages are approximately equal at nodes 50 and 24, respectively. Now, transistor 14 draws a collector current larger than $I_{out1}$ because it is still biased by transistor 15. Therefore, the discharge mechanism of the capacitance amplification circuit is again determined by the differential current ($I_{out2}$ - $I_{out1}$) and the Miller effect of the gain transistor Q2. Hence, the time constant is similarly determined by the values of the Miller capacitance and the equivalent resistance value simulated by the transconductance such that the low pass filtering mechanism is similar for increasing and decreasing input voltages. The charging and discharging mechanism of the capacitor 38 is now completely symmetrical and equilibrium can only be reached when the output and input voltages are equal. When the output and input voltages are equal, $I_{out2}$ - $I_{out1}$ = 0 because $g_m$ x ($V_{in}$ - $V_o$) = 0. This symmetrical charging/discharging characteristic of the invention reduces, if not eliminates, dynamic distortion.

The present invention also overcomes the drawbacks of limited driving capability of other prior-art filtering circuits. In the present invention, any mismatch in $I_{out1}$ and $I_{out2}$ will lead to a corresponding change in output voltage $V_o$ and the differential current will bring it back to its original level by the feedback action. For instance, if some current, for example a loading current ($I_L$) is needed from $I_{out1}$ for the next stage circuit bias, specifically the bipolar comparator 44 drawing an input bias current, the capacitor 38 will be discharged to make sure that the current flowing into the gain transistor 14 equals the current in the other bipolar transistor 15, which is $I_{out2}$. The output voltage $V_o$ will then decrease and the transconductance amplifier 202 will convert the voltage difference into a differential current and try to increase $I_{out2}$ until $I_{out2}$ is capable of supporting the loading current plus the current flowing through the gain transistor 14 which equals to $I_{out1}$. Therefore, $I_{out2}$ = $I_{out1}$ +$I_L$ and $V_{in}$ = $V_o$ at equilibrium.

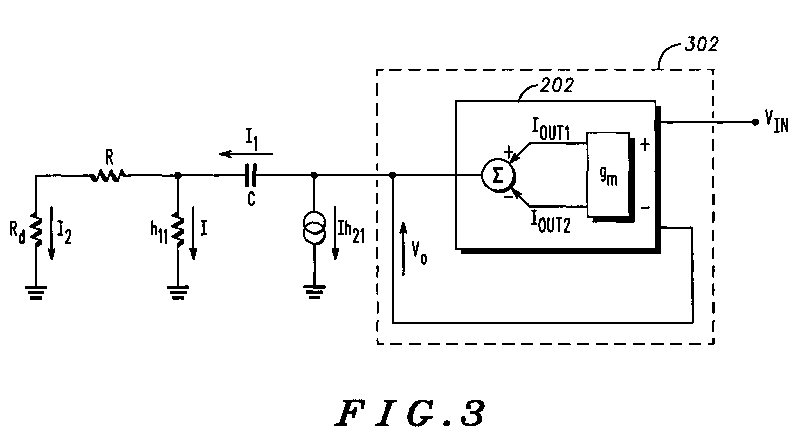

Referring to FIG. 3, a small signal equivalent circuit of a simple single pole and single zero low pass active analog filter, in accordance with the teachings of the present invention is shown. How the 3-dB bandwidth is determined by the gain amplifier 14, the transconductance amplifier with a differential output 202, and the filtering capacitor 38 can be better understood by considering its small signal equivalent circuit in FIG. 3 with the following considerations:

Where

$h_{11}$ = $h_{21}$ KT/qI = input base resistance of transistor 14
$h_{21}$ = transistor current gain of the small signal collector current through transistor 14
K = Boltzmann's constant
T = Absolute temperature
q = electron charge
$g_m$ = transconductance of transistor
R = resistance value of resistor 212 or resistor 214
$I_1$ = $I_{out1}$ - $I_{out2}$- $h_{21}$=$I_{in}$-$h_{21}$
I = $I_1$-$I_2$ = the small signal base current of transistor 14
$R_d$ = KT/(qI$_{out2}$) = the small signal resistance of the diode-connected transistor 15 to ground

By Kirchhoff's current law:

$$I_{in} = I_1 + h_{21} \text{ x I and } I_1 = I + I_2 \qquad [1]$$

$$\text{where } I_{in} = (V_{in} - V_o)/(1/g_m) \qquad [2]$$

$$\text{and } I_2(R+R_d) = Ih_{11} \qquad$$

By Kirchhoff's voltage law:

$$V_o = I_1/jCw+R_e \text{ x} I_1 \qquad [3]$$

where $R_e$ = the equivalent resistance of (R + $R_d$) parallel (//) to $h_{11}$

By dividing Vo by $I_{IN}$: [eq.2]/[eq.1]

$$V_o/I_{IN} = (1 + jR_e Cw)/jwC' \qquad [4]$$

Let C' = C[1 + $h_{21}$(R + KT/qI$_{out2}$)/(R + KT/qI$_{out2}$ + $h_{11}$)]

Solving for Vin in equation 2:

$$V_{in} = I_{in}/g_m + V_o$$

The transfer function is then:

$$V_{out}/V_{in} = V_o/[I_{in}/(V_o g_m) + 1] \qquad [5]$$

After substituting equation 4 into equation 5 and simplifying, the transfer function simplifies as follows:

$$V_o/V_{in} = (1+jwCR_e)/[1+(jwCR_e+jwC')/g_m]$$

Assuming $jwC' >> jwCR_e$, there is a pole frequency $fp = g_m/(2\pi C')$ and a zero frequency $fz = 1/(2\pi R_e C)$.

Hence, the transconductance amplifier 202 simulates an appropriate resistance ($R_f$) value of 1/gm for forming a low-pass filter with the feedback or filtering capacitor 38 in providing the filtered output at the output node 50. At low frequencies, below the zero frequency of $1/(2\pi R_e C)$, the gain asymptotically approaches the zero frequency gain value of 0dB. At high frequencies, above the pole frequency of gm/$(2\pi C')$, the gain will asymptotically approach a response given by a zero determined by the filtering capacitor 38 and bias collector current of the transistor 14 and drop off at a rate of minus (-)20dB/decade or -6dB/octave afterwards.

In summary, the present invention provides a method for implementing a first order low-pass (LP) filter needing no external components by using a low-value on-chip capacitor to save die area. In accordance with the invention, an electrical signal filter device and integration method may be provided utilizing a voltage-current converter or transconductance amplifier to allow the direct implementation of a very small transconductance to give an electrically adjustable low-pass cutoff frequency. A very large time-constant integrator is formed by feeding the output current into a Miller multiplicated capacitor. The combination of the two circuits configured in a feedback arrangement with the differential outputs of the transconductance amplifier controlling the bias and active load currents of the capacitance amplification circuit renders the present invention with advantages such as a low output offset voltage, a low output offset voltage drift with temperature, and a high driving capability.

**Claims**

1. A filter comprising:

   a first variable current source;
   a second variable current source;
   a first common-emitter amplifier having a first base node, a fixed bias reference port coupled to the first variable current source;
   a second common-emitter amplifier having a second base node, an amplified feedback port coupled to the second variable current source and for providing a filtered output;
   a first resistor coupled from the first base node to the fixed bias reference port;
   a second resistor coupled from the second base node to the fixed bias reference port;
   a feedback capacitor having one end coupled to the second base node and a second end coupled to the amplified feedback port of the second common-emitter amplifier such that the second amplifier exerts a Miller multiplication effect on the feedback capacitor when the capacitor is charged and discharged; and
   a transconductance amplifier for simulating an appropriate resistance value for forming a low-pass filter with the feedback capacitor in providing the filtered output, the transconductance amplifier having a first input and a first output of a first polarity and a second input and a second output of a second polarity, the first input for receiving a reference signal, the second input coupled to the amplified feedback port, the second output coupled to the first variable current source and the first output coupled to the second variable current source for providing a differential current for varying the first and second current sources to charge-up the feedback capacitor when the reference signal is higher than the filtered output and for varying the first and second current sources to discharge the feedback capacitor when the reference signal is lower than the filtered output.

2. The filter of claim 1, wherein the feedback capacitor comprises a monolithic capacitor.

3. The filter of claim 1, wherein the feedback capacitor comprises an on-chip capacitor of 150pF.

4. The filter of claim 1, wherein the fixed bias port comprises a first collector node.

5. The filter of claim 4, wherein the amplified feedback port comprises a second collector node.

6. The filter of claim 4, wherein the transconductance amplifier comprises a voltage-to-current converter having a differential output.

7. An electrical signal filter device having a selectable low pass cutoff frequency that is adjustable, the device comprising:

a transconductance amplifier having a transconductance value $g_m$ for simulating a resistance value of $1/g_m$, the transconductance amplifier having a first input node electrically connectable to receive input signals to be filtered and a second input node, the transconductance amplifier having a differential output; and

a Miller capacitance amplification integrator coupled to the transconductance amplifier, the integrator having a reference current source and an active load for copying the differential output of the transconductance amplifier for providing the bias and active load currents of the Miller capacitance amplification integrator and for providing a multiplied capacitance value for combining with the resistance value for realizing the resistance-capacitance time constant value.

8. The device of claim 7, wherein the Miller capacitance amplification integrator comprises:

a gain transistor having a current gain ($h_{21}$), an input and an output for providing a filtered output signal; and an on-chip capacitor having a capacitance value, the capacitor connected across the input and output of the gain transistor to provide a Miller capacitance multiplication effect and wherein the low pass cutoff frequency provided at the output of the gain transistor is a function of the $g_m$ of the transconductance amplifier, the on-chip capacitance value and the current gain ($h_{21}$) of the gain transistor.

9. The device of claim 7, wherein the Miller capacitance amplification integrator comprises:

a first variable current source;
a second variable current source;
a first common-emitter amplifier having a first base node, a fixed bias reference port coupled to the first variable current source;
a second common-emitter amplifier having a second base node, an amplified feedback port coupled to the second variable current source and for providing a filtered output;
a first resistor coupled from the first base node to the fixed bias reference port;
a second resistor coupled from the second base node to the fixed bias reference port;
a feedback capacitor having one end coupled to the second base node and a second end coupled to the amplified feedback port of the second common-emitter amplifier such that the second amplifier exerts a Miller multiplication effect on the feedback capacitor when the capacitor is charged and discharged by the transconductance amplifier.

10. An integrated automobile control chip, comprising:

a regulator having an input regulator signal;
a filter coupled to the regulator for filtering the input regulator signal, the filter comprising:
a transconductance amplifier having a transconductance value $g_m$ for simulating a resistance value of $1/g_m$, the transconductance amplifier having a first input node electrically connectable to receive the regulator input signal and a second input node, the transconductance amplifier having a differential output; and
a Miller capacitance amplification integrator coupled to the transconductance amplifier, the integrator having a reference current source and an active load for copying the differential output of the transconductance amplifier for providing the bias and active load currents of the Miller capacitance amplification integrator and for providing a multiplied capacitance value for combining with the resistance value for realizing the resistance-capacitance time constant value.

**FIG.1**

EP 0 907 250 A2

FIG.2

$FIG.3$